Europäisches Patentamt

(19) European Patent Office

Office européen des brevets

(11) Publication number: **0 193 745**
**B1**

# EUROPEAN PATENT SPECIFICATION

(45) Date of publication of the patent specification:
30.08.89

(51) Int. Cl.⁴: **B23B 47/34**

(21) Application number: **86101470.2**

(22) Date of filing: **05.02.86**

(54) Drilling machine comprising a pressure foot with a contact pad.

(30) Priority: **06.03.85 US 708961**

(43) Date of publication of application:
**10.09.86 Bulletin 86/37**

(45) Publication of the grant of the patent:
**30.08.89 Bulletin 89/35**

(84) Designated Contracting States:
**DE FR GB IT**

(56) References cited:
**CH-A- 303 726**
**DE-C- 634 784**
**US-A- 2 420 905**

(73) Proprietor: **International Business Machines
Corporation, Old Orchard Road, Armonk, N.Y. 10504(US)**

(72) Inventor: **Scales, Eugene Monagon, R.D. No. 2,
Box 225-C. King Hill Road, Endicott, N.Y. 13760(US)**
Inventor: **Wagner, Frederick, R.D. No. 1, Box 53 Pierce
Hill Road, Vestal New York 13850(US)**

(74) Representative: **Möhlen, Wolfgang C., Dipl.-Ing., IBM
Corporation Säumerstrasse 4, CH-8803 Rüschlikon(CH)**

Note: Within nine months from the publication of the mention of the grant of the European patent. any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

This invention relates to a drilling machine employing a pressure foot for precision drilling of holes to designated depths and, more particularly, to a drilling machine with a pressure foot having a contact pad.

Drilling machines are employed in numerous industrial situations for fabricating a large variety of products. One situation of particular interest is the fabrication of electronic printed circuit boards and similar products which require the drilling of very fine holes to a high degree of precision. Circuit boards are frequently constructed as a laminate of copper and dielectric layers, with the dielectric being formed typically of a mixture of fibrous glass and epoxy. Certain fabrication processes require the drilling of a hole part way into the laminated circuit board, the hole passing through an outer copper layer and part way into the dielectric layer.

As an example of such a precision hole, sometimes referred to as a "spotface hole", a hole having a diameter of 0.125 inch (3,175 mm) and a depth of 0.004 ± 0.005 inch (0,102 ± 0,013 mm) serves as a window for x-ray examination of internal plane alignment of a laminated panel such as that of the foregoing circuit board.

A problem arises in that commercially available drilling equipment is not able to drill the foregoing spotface hole with sufficient precision to repeatably attain the foregoing depth requirement. In the usual construction of such equipment, the drilling machine includes a spindle which rotates a drill bit formed as a boring bar, and further includes a pressure foot which encircles the drill bit. The pressure foot has a registration contact pad which contacts the surface to be drilled. The pressure foot serves as a depth gauge for stopping a forward advance of the drill bit to attain the desired depth of hole. The pressure foot also is provided with apertures through which air is drawn under vacuum to clear debris from the area of the workpiece being drilled.

In the foregoing equipment, an interface between a contacting surface of the contact pad and the surface of the workpiece serves as the reference plane from which the hole depth is measured. Any undulation or unevenness in the surface of the workpiece, or the presence on the workpiece surface of debris such as is produced by a drilling operation, detracts from the positional accuracy of the reference plane with a consequent loss of control in maintaining the desired hole depth. The foregoing equipment appears to be unable to accommodate adequately to the undulations and unevenness in the surface, and the apertures, or vacuum ports, in the pressure foot appear to be unable to provide sufficient direction of the vacuum air draft for reliable removal of all interfering debris from the interface between the contact pad and the workpiece surface.

The foregoing problem is overcome and other advantages are provided by a drilling machine having a drill bit and a pressure foot encircling the drill bit, the pressure foot having a contact pad with a central bore which serves as a passage for receiving the drill bit. It is an object of the invention to reduce the susceptibility of the reference plane position to undulations and unevenness in the surface of the workpiece by reducing the area of interface between the contact pad and the workpiece, and by minimizing spacing between the drill bit and the encircling contact pad. It is a further object of the invention to improve direction of vacuum air flow for better removal of debris from the area of interface between the contact pad and the workpiece.

These objects are met in accordance with the invention by the drilling machine defined in claim 1.

The foregoing features of the invention are explained in the following description of an embodiment of the invention taken in connection with the accompanying drawing wherein:

Figure 1 is a simplified and stylized view of a drilling machine including a pressure foot of the prior art positioned between a drill chuck and a workpiece, the machine including a vacuum operated debris removal system;

Figure 2 is a plan view, looking up from a workpiece, of a pressure foot constructed in accordance with the invention with a drill passage having a side extension service as a duct for direction of vacuum; and

Figure 3 is a side elevation view of the pressure foot of Figure 2 showing a registration contact pad of reduced cross section.

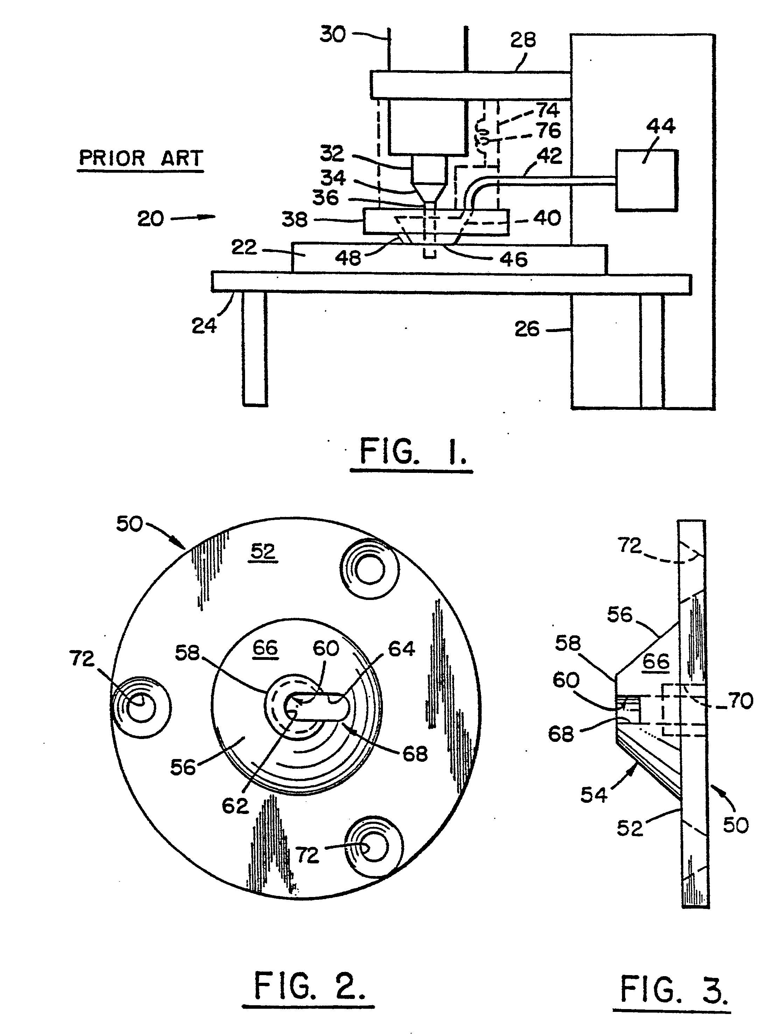

Figure 1 shows a stylized view of a drilling machine 20 which is typical of machines currently employed in drilling holes in electronic circuit boards exemplified by the workpiece 22 set on a table 24. The drilling machine 20 includes a cabinet 26 having a movable arm 28 extending therefrom horizontally and holding a motor 30 at the outer end of the arm 28. A spindle 32 and chuck 34 extend from the motor 30 and are driven in rotation by the motor 30. A drill bit 36 is held within the chuck 34 and passes through a pressure foot 38 to contact the workpiece 22.

The pressure foot 38 includes a chamber 40 connected by a flexible hose 42 to a vacuum pump 44, and opens into a vacuum port 46 in a contact pad 48 on the underside of the pressure foot 38.

The contact pad 48 is integrally formed with the pressure foot 38 and is provided with an outer rim surface which contacts the upper surface of the workpiece 22. The vacuum port 46 is located within the rim of the pad 48, and the drill bit 36 passes along a central axis of the port 46 and the pad 48.

In operation, the arm 28 is moved vertically by a mechanism (not shown) within the cabinet 26 for advancing the drill bit 36 into the workpiece 22 during a drilling of a hole therein, and for retracting the drill bit 36 from the workpiece 22 upon completion of the drilling. During the drilling, the motor 30 rotates the drill bit 36 to provide a cutting action whereby the hole is bored. Debris resulting from the drilling operation is drawn away from the site of the drilling by the vacuum within the chamber 40. The pressure foot 38 may be used as a stop for engaging with a housing of the motor 30 to limit the depth of penetration of the drill bit 36 into the workpiece 22.

When the pressure foot 38 is used to limit the vertical travel of the drill bit 36, the pressure foot 38 is, in essence, being used as a depth gauge for determining the depth of a hole bored by the drill bit. A reference plane for such depth gauge is established at the interface of the rim of the contact pad 48 with the surface of the workpiece 22. Any irregularities in the surface of the workpiece 22 will displace the reference plane resulting in a lack of precision and repeatability and the drilling of a succession of holes in the workpiece 22. The vacuum in the chamber 40 also aids in clearing debris from the interface between the pad 48 and the workpiece 22, so as to reduce errors in depth associated with such debris. The mechanism whereby the pressure foot 38 comes into abutment with the housing of the motor 30 has been deleted in the figure to simplify the presentation, such mechanisms being well known.

Figures 2 and 3 show a pressure foot 50 incorporating the invention. The pressure foot 50 comprises a base 52 with a contact pad 54 extending away from the base 52. The pad 54 comprises a housing 56 having a frusto-conical shape extending from the base 52 to a rim 58 of the pressure foot 50.

Within the housing 56 is located a passage 60 formed as a central bore 62 along an axis of the housing 56 and being provided with a chamber 64 of elongated cross-section extending radially outward from the bore 62 into the side wall of the bore 62. The chamber 64 has an elongated shape extending parallel to the axis of the housing 56, this shape of the chamber 64 enabling the chamber 64 to serve as a duct for the application of vacuum to the area of a workpiece such as the workpiece 22 of Figure 1, in which a drilling operation is proceeding.

The chamber 64 terminates at the rim 58 and also extends sideways into the frusto-conical surface at 66 to provide a vacuum port 68. Thus, a portion of the port 68 opens directly on the rim 58, while a further portion of the port 68 opens on the surface 66.

The portion of the bore 62 at and near the base 52 is enlarged in diameter to provide a region 70 into which the chuck 34 (Figure 1) can descend during a drilling operation. Also, the base 52 is provided with countersunk holes 72 which receive screws (not shown) for mounting the pressure foot 50 to a drilling machine such as the machine 20 of Figure 1. In particular, it is noted that such machines have a well-known frame, indicated in phantom at 74 in Figure 1, whereby a pressure foot, such as the foot 50 is secured in registration with a spindle, such as the spindle 32 of Figure 1. The frame 74 may include a spring 76 (Figure 1) which exerts a predetermined pressure between the pressure foot 38 or 50 against the workpiece 22 as the spindle 32 advances toward the workpiece 22.

In the construction of the pressure foot 50 the size of the bore 62 is selected in accordance with the size of the drill bit 36. Thus, the diameter of the bore 62 is only fractionally larger, for example, 10% larger than the diameter of the drill bit 36 so as to provide adequate clearance for the drill bit 36 to enable the drill bit 36 to travel along the passage 60 during a drilling operation. By minimizing the diameter of the bore 62, the size of the rim 58 is also minimized to provide a two-fold benefit to the precision of drilling a hole in the workpiece 22. The outer diameter of the rim 58 is selected so as to provide a contact area to the pad 54 which can support the force of the pressure foot 50 against the workpiece 22 without deforming or otherwise injuring the surface of the workpiece 22. The minimization of the inner and outer radii of the rim 58 insure that any perterbations in the surface of the workpiece 22 at a considerable distance from the drilling site will have no effect on the establishment of the reference plane from which hole depth is measured. In addition, the minimization of the contact area of the rim 58 minimizes the possibility of interference in the establishment of the reference plane because of nearby perterbations in the surface of the workpiece 22.

With respect to the joining of the pressure foot 50 to a drilling machine such as the machine 20 of Figure 1, the pressure foot 50 may be secured by its base 52 to a housing (not shown) similarly shaped to the base portion of the pressure foot 38 to permit the connection of the vacuum hose 42 to the pressure foot 50. Thereby, suction may be applied to the chamber 64 for initiating a flow of air into the port 68 for drawing debris into the chamber 64 and further into the hose 42 for removal from the drilling site. A feature of the invention is found in the enplacement of the port 68 directly at the rim 58. In view of the relatively small size of the rim 58, there is reduced space in which debris can collect at the interface between the contact pad 54 and the workpiece 22. Thus, the vacuum in the chamber 64 is better able to clear the region of interface between the pad 54 and the workpiece 22. The extension of the port 68 onto the surface 66 at the side of the rim 58 further allows the withdrawal of debris from the immediately surrounding surface of the workpiece 22.

As an example in the dimensions of an embodiment of the pressure foot 50, the diameter of the bore is 0.1875 inch (4,763 mm), this also being the cross-sectional width of the port 68. The over-all cross-sectional length of the port 68, as viewed in the plan view of Figure 2, is 0.4375 inch (11,113 mm). The height of the port 68, as viewed in the elevation view of Figure 3, is 0.145 inch (3,683 mm). The spacing between the center of a hole 72 and the center of the base 52 is 0.880 inch (22,352 mm). The diameter of the housing 56 at the base 52 is 1.000 inch (25,400 mm). The height of the housing 56 and of the contact pad 54 above the surface of the base 52, as viewed in the elevation view of Figure 3, is 0.325 inch (8,255 mm). The thickness of the base 52 is 0.125 inch (3,175 mm). The diameter of the region 70 is 0.3125 inch (7,938 mm). The diameter of the base 52 is 2.125 inch (53,98 mm).

## Claims

1. Drilling machine having a drill bit and a pressure foot encircling the drill bit, wherein said pressure foot (50) comprises a contact piece (54), there being a bore (62) extending through said contact piece for receiving said drill bit (36); said contact piece having a frusto-conical shape (56, 66), the wider end being mounted on a base plate (52), and a contacting surface (58) being located at the narrower end away from said base plate; characterized in that

    — the diameter of said bore (62) is fractionally larger than the diameter of said drill bit (36) to provide clearance of said drill bit during passage thereof through said bore;

    — said contacting surface (58) has an outer diameter less than twice the diameter of said bore for contacting only the area of a workpiece adjacent to said drill bit during a drilling operation for precision in drilling; and

    — said pressure foot further comprises a vacuum port (68) for removal of debris, formed as a lateral extension of said bore and opening at said contacting surface and along an adjacent portion of the inclined, conical surface (56, 66) of said contact piece.

2. Drilling machine according to Claim 1, characterized in that the cross-section of said vacuum port (68) is elongated in a direction away from said bore (62), the width of said cross-section being equal to the diameter of said bore.

3. Drilling machine according to Claim 1 or Claim 2, characterized in that the cross-section of said vacuum port (68) is symmetrically located about a radius of said bore (62).

**Patentansprüche**

1. Bohrmaschine mit einem Bohrer und einem Druckfuss, der den Bohrer umgibt, wobei der Druckfuss (50) ein Kontaktstück (54) enthält mit einer Bohrung (62), welche sich durch das Kontaktstück hindurch erstreckt, zur Aufnahme des Bohrers; und wobei das Kontaktstück die Form eines Kegelstumpfes (56) hat, von dem das breitere Ende auf einer Grundplatte (52) montiert ist und bei dem sich eine Kontaktfläche (58) am schmaleren Ende, abseits der Grundplatte, befindet; dadurch gekennzeichnet, dass

    — der Durchmesser der Bohrung (62) nur bruchteilsmässig grösser als der Durchmesser des Bohrers (36) ist, um für den Bohrer, wenn er durch die Bohrung geführt ist, einen lichten Zwischenraum zu lassen;

    — die Kontaktfläche (58) einen äusseren Durchmesser hat, welcher weniger als das Zweifache des Durchmessers der Bohrung beträgt, um, zwecks Genauigkeit des Bohrens, nur den Bereich eines Werkstückes während einer Bohroperation zu berühren, welcher sich in der Nähe des Bohrers befindet; und dass

    — der Druckfuss eine Vakuumöffnung (68) zur Entfernung von Spänen hat, welche als seitliche Ausweitung der Bohrung geformt ist und sich in der Kontaktfläche und längs dem anschliessenden Teil der geneigten, konischen Oberfläche (56, 66) des Kontaktstückes öffnet.

2. Bohrmaschine gemäss Anspruch 1, dadurch gekennzeichnet, dass der Querschnitt der Vakuumöffnung (68) länglich ist, und zwar in einer Richtung weg von der Bohrung (62), wobei die Breite des Querschnittes gleich dem Durchmesser der Bohrung ist.

3. Bohrmaschine gemäss Anspruch 1 oder 2, dadurch gekennzeichnet, dass der Querschnitt der Vakuumöffnung (68) symmetrisch zu einem Radius der Bohrung (62) ist.

**Revendications**

1. Perceuse comprenant un foret et une semelle presseuse entourant le foret, dans laquelle la semelle presseuse (50) comprend une pièce de contact (54), un alésage (62) s'étendant au travers de cette pièce de contact pour recevoir le foret (36), cette pièce de contact ayant une forme tronconique (56, 66), l'extrémité la plus large étant montée sur une plaque support (52), et une surface de contact (58) étant disposée au niveau de l'extrémité la plus étroite et éloignée de la plaque support; caractérisée en ce que:

    — le diamètre de l'alésage (62) est d'une fraction supérieure au diamètre du foret (36) pour laisser un jeu pour le foret pendant le passage de celui-ci au travers de l'alésage;

    — la surface de contact (58) a un diamètre externe inférieur à deux fois le diamètre de l'alésage pour venir en contact avec la seule zone de la pièce à usiner adjacente au foret pendant une opération de perçage pour un perçage de précision; et

    — la semelle presseuse comprend en outre un accès de dépression (68) pour l'enlèvement de débris, formé en tant qu'extension latérale dudit alésage et s'ouvrant au niveau de la surface de contact et selon une partie adjacente de la surface conique inclinée (56, 66) de la pièce de contact.

2. Perceuse selon la revendication 1, caractérisée en ce que la section de l'accès de dépression (68) est allongée dans une direction qui s'éloigne de l'alésage (62), la largeur de ladite section étant égale au diamètre de l'alésage.

3. Perceuse selon l'une des revendications 1 ou 2, caractérisée en ce que la section dudit accès de dépression (68) est disposée de façon symétrique autour d'un rayon dudit alésage (62).

EP 0 193 745 B1

PRIOR ART

FIG. 1.

FIG. 2.

FIG. 3.